# EUROPÄISCHE PATENTSCHRIFT

(11) **EP 0 726 448 B1**
(45) Veröffentlichungstag und Bekanntmachung des Hinweises auf die Patenterteilung: **06.10.1999**
(21) Anmeldenummer: 95118330.0
(22) Anmeldetag: 22.11.1995
(51) Int. Cl.: G01D 5/14, G01D 5/16, G01R 33/06

(54) **Magnetische Positionssensoreinrichtung**
Magnetic position sensor
Capteur magnétique de position

(30) Priorität: 09.02.1995 DE 19504229
(43) Veröffentlichungstag der Anmeldung: 14.08.1996
(73) Patentinhaber: FESTO AG & Co, 73734 Esslingen (DE)
(72) Erfinder: Stoll, Kurt, Dipl.-Ing. Dr., D-73732 Esslingen (DE); Reininger, Thomas, Dr., D-73249 Wernau (DE)
(74) Vertreter: Vetter, Hans, Dipl.-Phys. Dr.

(56) Entgegenhaltungen:
- EP-A- 0 390 261
- EP-A- 0 591 113
- EP-A- 0 707 190
- WO-A-90/09563

## Beschreibung

Die Erfindung betrifft eine Positions-Sensoreinrichtung mit einem in einer Langsrichtung bewegbaren, einen Permanentmagneten aufweisenden Element und mit wenigstens einem an der Bewegungsbahn ortsfest angeordneten magnetfeldempfindlichen Sensor.

Magnetfeldempfindliche Sensoren sind in verschiedenen Ausführungen bekannt, insbesondere als Hall-Elemente oder als magnetoresistive Elemente (Feldplatten). In der Zeitschrift "electronic industrie", Heft 5/85 und 6/85, "Magnetfeldempfindliche Halbleiter-Positionssensoren" sind solche Sensoren und ihre Anwendungen beschrieben. Um das Erreichen einer Position eines sich bewegenden Elements bestimmen zu können, wird dieses mit einem Permanentmagneten versehen, und an der zu detektierenden Stelle wird ein solcher Sensor seitlich an der Bewegungsbahn angebracht. Die verschiedenen magnetfeldempfindlichen Sensoren weisen nun jeweils unterschiedliche Vorteile und Nachteile auf. Wird beispielsweise ein Hall-Element verwendet, so kann dieses zwar die beiden unterschiedlichen Feldrichtungen des Magnetfelds unterscheiden, jedoch wird dabei jeweils nur diejenige Feldkomponente erfaßt, die senkrecht zur Fläche des Hall-Elements verläuft. Wird dagegen ein magnetoresistives Element bzw. eine Feldplatte eingesetzt, so wird die Feldkomponente parallel zur Fläche dieses Elements erfaßt. Ein solches Element kann jedoch die beiden entgegengesetzten Feldrichtungen nicht unterscheiden. Diese Elemente sind sehr empfindlich, jedoch treten systembedingt neben einem Hauptsignal noch Nebensignale auf, die zu unerwünschten Mehrfach-Positionssignalen führen können. Obwohl daher prinzipiell eine große Sensorempfindlichkeit angestrebt wird, kann diese zur Vermeidung dieser Mehrfach-Signale nicht genutzt werden.

Aus der älteren, jedoch nicht vorveröffentlichten EP 0 707 190 ist eine langgestreckte, magnetfeldempfindliche Spule bekannt, entlang der ein Permanentmagnet bewegbar ist. Die nicht-linearen Randbereiche der Sekundärspule werden mittels zwei neben der Spule angeordneten Magnetfeldsensoren ausgeblendet. Die Probleme einer Vermeidung von Mehrfach-Signalen sind in dieser Druckschrift nicht angesprochen.

Eine Aufgabe der Erfindung besteht daher darin, die optimale Empfindlichkeit dieser Sensoren zu nutzen und dabei gleichzeitig die Gefahr von Mehrfach-Signalen abzuwenden.

Diese Aufgabe wird erfindungsgemäß dadurch gelöst, daß zwei erste, auf die Feldkomponente senkrecht zur Bewegungsrichtung des Permanentmagneten ansprechende und in dieser Bewegungsrichtung hintereinander angeordnete Sensoren vorgesehen sind, zwischen denen ein auf die Feldkomponente parallel zur Bewegungsrichtung der Permanentmagneten ansprechender dritter Sensor angeordnet ist, wobei die Ansprechsignale der beiden ersten Sensoren ein Meßfenster zur Ausblendung von neben dem Hauptsignal auftretenden Nebensignalen des dritten Sensors bilden und die drei Sensoren in der Bewegungsrichtung hintereinander angeordnet sind.

Durch das Ausblenden der störenden Anteile in der Magnetverteilung durch die beiden ersten Sensoren kann eine solche Positions-Sensoreinrichtung einerseits beliebig dicht an der Bahn des Permanentmagneten sitzen, und andererseits kann der maximale Abstand durch Erhöhung der Empfindlichkeit des dritten Sensors vergrößert werden. Die Länge bzw. Größe des den aktiven Bereich bildenden Meßfensters kann im wesentlichen durch den geometrischen Abstand der beiden ersten Sensoren eingestellt werden. Man erreicht dadurch eine sehr empfindliche und präzise Sensoreinrichtung, bei der die Gefahr von Mehrfach-Signalen dennoch ausgeschlossen ist.

Durch die in den Unteransprüchen aufgeführten Maßnahmen sind vorteilhafte Weiterbildungen und Verbesserungen der im Anspruch 1 angegebenen Positions-Sensoreinrichtung möglich.

Der Permanentmagnet ist zweckmäßigerweise in der Bewegungsrichtung axial magnetisiert, so daß der auf die Feldkomponente parallel zur Bewegungsrichtung des Permanentmagneten ansprechende dritte Sensor ein gutes Meßsignal erhält.

Für die beiden ersten Sensoren eignen sich vor allem kostengünstige Hall-Sensoren, die vorzugsweise als uniaxiale, bistabile Hall-Sensoren ausgebildet sind. Diese können flach eingebaut werden, um die Feldkomponente senkrecht zur Bewegung des Permanentmagneten detektieren zu können. Hierdurch wird automatisch das Meßfenster dadurch gebildet, daß unterschiedliche Sensorsignale dieser beiden ersten Sensoren vorliegen. Derartige Sensoren können platzsparend neben der Bewegungsbahn des Permanentmagneten angeordnet werden. Außerdem können diese Sensoren zusätzlich zur Erkennung der Bewegungsrichtung des Permanentmagneten und zur Erkennung der Position desselben verwendet werden, also zur Erkennung, ob sich der Permanentmagnet links oder rechts neben dem Meßfenster oder im Meßfenster befindet. Dies wird durch die Eigenschaft der Hall-Sensoren ermöglicht, die Richtung der jeweiligen Feldkomponente zu erfassen.

Zur Bildung des Meßfensters können einfache elektronische Mittel vorgesehen werden, die bei ungleichem Schaltzustand der beiden Hall-Sensoren ein das Meßfenster definierendes Signal erzeugen.

Der dritte Sensor ist in vorteilhafter Weise als magnetoresistiver Sensor mit hoher Empfindlichkeit ausgebildet.

In konstruktiv günstiger Weise können die Sensoren als flache Plättchen in einer Ebene nebeneinander angeordnet werden, vorzugsweise auf einer Trägerplatte zusammen mit der Auswerteschaltung, so daß ein einziges Bauelement von geringer Größe die vollständige Positions-Sensoreinrichtung bilden kann. Hierzu ist die Trägerplatte insbesondere als Si-Träger ausgebildet, wobei die Sensoren und die Auswerteschaltung eine durch einen Batch-Prozeß gebildete Struktur aufweisen.

In einer vorteilhaften Kombination mit einer Kolben-Zylinder-Einheit sind der Permanentmagnet an oder in einem Kolben dieser Kolben-Zylinder-Einheit und die Sensoren an oder in der Zylinderwandung angeordnet. Durch die flache Anordnung der Sensoren eignet sich die Sensoreinrichtung hierfür besonders gut, und die Kolbenposition kann sehr präzise erfaßt werden.

Ein Ausführungsbeispiel der Erfindung ist in der Zeichnung dargestellt und in der nachfolgenden Beschreibung näher erläutert. Es zeigen:
- Fig. 1: eine perspektivische Darstellung der Positions-Sensoreinrichtung,
- Fig. 2: ein Signaldiagramm zur Erläuterung der Wirkungsweise und
- Fig. 3: ein Blockschaltbild der Auswerteschaltung.

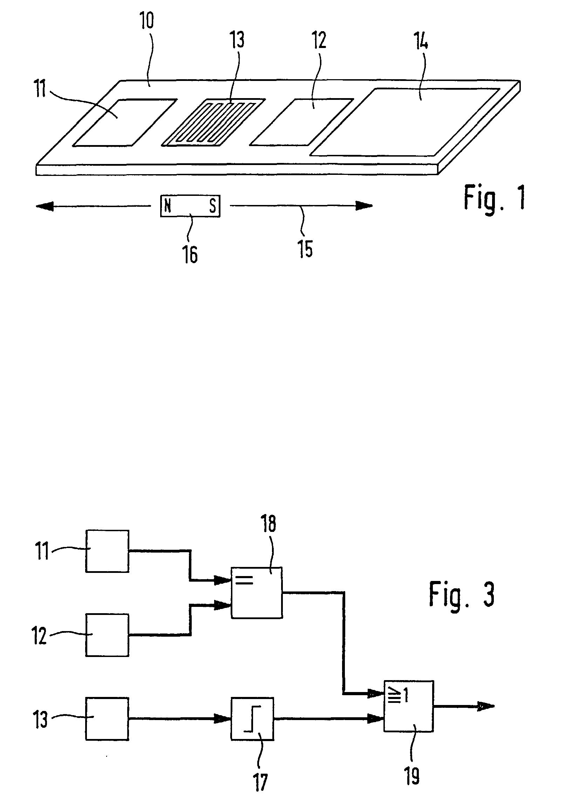

Bei dem in Fig. 1 dargestellten Ausführungsbeispiel sind auf einem als Si-Plättchen ausgebildeten Träger 10 durch einen Batch-Prozeß die Komponenten der Positions-Sensoreinrichtung aufgebracht. Es handelt sich dabei um erste und zweite Sensoren 11, 12, die als uniaxiale, bistabile Hall-Elemente ausgebildet sind, und zwischen denen ein als magnetoresistives Element bzw. Feldplatte ausgebildeter dritter Sensor 13 angeordnet ist. Weiterhin ist eine Auswerteschaltung 14 auf dem Träger 10 angeordnet, wie sie in Zusammenhang mit Fig. 3 noch näher erläutert wird.

Die somit insgesamt als flaches Plättchen ausgebildete Sensoreinrichtung wird neben der Bewegungsbahn 15 eines Permanentmagneten 16 so angeordnet, daß die drei Sensoren 11 - 13 in der Bewegungsrichtung hintereinander angeordnet sind. Der Permanentmagnet ist dabei in der Bewegungsrichtung (axial) magnetisiert.

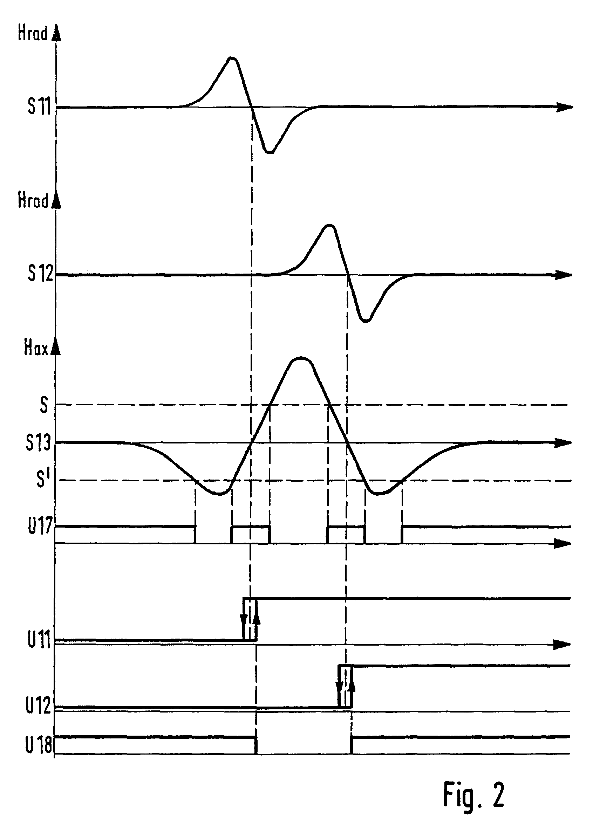

Beim Passieren der Sensoreinrichtung sprechen der erste und zweite Sensor 11, 12 auf die radiale Feldkomponente des Magnetfelds des Permanentmagneten 16 an, also auf die senkrecht zur Bewegungsbahn 15 des Permanentmagneten 16 gerichtete Feldkomponente. Dagegen spricht der dritte Sensor 13 auf die axiale Feldkomponente dieses Feldes an, also auf die Komponente parallel zur Bewegungsbahn 15 des Permanentmagneten 16. Der Verlauf der radialen Feldkomponente, auf den die Sensoren 11 und 12 ansprechen, ist in Fig. 2 jeweils als S11 und S12 dargestellt, während die für den Sensor 13 maßgebliche axiale Feldkomponente mit S13 bezeichnet ist. Gemäß Fig. 3 wird das Sensorsignal des Sensors 13 einer Signalformerstufe 17 zugeführt, die beispielsweise ein Schmitt-Trigger sein kann. Das Ausgangssignal dieser Signalformerstufe 17 ist in Fig. 2 mit U17 bezeichnet. An der Signalfolge U17 sind neben dem mittleren Hauptsignal die seitlichen unerwünschten Nebensignale erkennbar.

Die Ausgangssignale der Sensoren 11 und 12 sind mit U11 und U12 bezeichnet. Diese beiden Signale werden gemäß Fig. 3 einem Äquivalenz-Gatter 18 zugeführt, das ein Low-Signal am Ausgang nur dann erzeugt, wenn die Eingangssignale unterschiedlich sind. Dieses Ausgangssignal U18 des Aquivalenz-Gatters 18 gibt ein Meßfenster vor. In Fig. 2 ist der Fall dargestellt, bei dem sich der Permanentmagnet 16 von links nach rechts bewegt.

Die Signale U17 und U18 werden gemäß Fig. 3 einem Nor-Gatter 19 zugeführt, durch das die Nebensignale der Signalfolge U17 ausgeblendet werden, so daß nur noch das erwünschte Hauptsignal als Positionsmeßsignal verbleibt.

Mit der dargestellten und beschriebenen Positions-Sensoreinrichtung läßt sich auch der Aufenthaltsort des Permanentmagneten 16 links oder rechts vom Sensor 13 feststellen. Weisen die Sensoren 11 und 12 beide ein Low-Signal auf, so befindet sich der Permanentmagnet 16 links von der Sensoreinrichtung, und bei Vorliegen von zwei High-Signalen ist die Position rechts vom Sensor 13. Auch die Bewegungsrichtung des Permanentmagneten 16 läßt sich durch die beiden Sensoren 11 und 12 bestimmen.

Bei Erfordernis, also beispielsweise bei anderer Ausführung der Hall-Sensoren 11 und 12, kann diesen ebenfalls eine Signalformerstufe bzw. ein Schmitt-Trigger nachgeschaltet sein.

Zur Positionsbestimmung eines Kolbens in einer Kolben-Zylinder-Anordnung kann der Permanentmagnet 16 beispielsweise in Form eines Ring-Magneten im Kolben integriert sein, während die sehr flache Sensoreinrichtung gemäß Fig. 1 an der Zylinderaußenwand angeordnet oder in der Zylinderwand eingelassen sein kann. Auf diese Weise kann durch Verwendung mehrerer Sensoreinrichtungen gemäß Fig. 1 eine entsprechende Zahl von Kolbenpositionen exakt bestimmt werden, beispielsweise Positionen in oder kurz vor den Endpositionen.

## Patentansprüche

1. Positions-Sensoreinrichtung mit einem in einer Längsrichtung bewegbaren, einen Permanentmagneten (16) aufweisenden Element und mit wenigstens einem an der Bewegungsbahn (15) ortsfest angeordneten magnetfeldempfindlichen Sensor (11, 12), dadurch gekennzeichnet, daß zwei erste, auf die Feldkomponente senkrecht zur Bewegungsrichtung des Permanentmagneten (16) ansprechende und in dieser Bewegungsrichtung hintereinander angeordnete Sensoren (11, 12) vorgesehen sind, zwischen denen ein auf die Feldkomponente parallel zur Bewegungsrichtung der Permanentmagneten (16) ansprechender dritter Sensor (13) angeordnet ist, wobei die Ansprechsignale der beiden ersten Sensoren (11, 12) ein Meßfenster zur Ausblendung von neben dem Hauptsignal auftretenden Nebensignalen des dritten Sensors (13) bilden und die drei Sensoren (11-13) in der Bewegungsrichtung hintereinander angeordnet sind.

2. Sensoreinrichtung nach Anspruch 1, dadurch gekennzeichnet, daß der Permanentmagnet (16) in der Bewegungsrichtung axial magnetisiert ist.

3. Sensoreinrichtung nach Anspruch 1 oder 2, dadurch gekennzeichnet, daß die beiden ersten Sensoren (11, 12) Hall-Sensoren sind.

4. Sensoreinrichtung nach Anspruch 3, dadurch gekennzeichnet, daß die Hall-Sensoren (11, 12) als uniaxiale, bistabile Hall-Sensoren ausgebildet sind.

5. Sensoreinrichtung nach Anspruch 3 oder 4, dadurch gekennzeichnet, daß elektronische Mittel (18) zur Bildung des Meßfensters vorgesehen sind, die bei ungleichem Schaltzustand der beiden Hall-Sensoren (11, 12) ein das Meßfenster definierendes Signal (U18) erzeugen.

6. Sensoreinrichtung nach einem der vorhergehenden Ansprüche, dadurch gekennzeichnet, daß der dritte Sensor (13) als magnetoresistiver Sensor ausgebildet ist.

7. Sensoreinrichtung nach einem der vorhergehenden Ansprüche, dadurch gekennzeichnet, daß die Sensoren (11 - 13) als flache Plättchen in einer Ebene nebeneinander angeordnet sind.

8. Sensoreinrichtung nach Anspruch 7, dadurch gekennzeichnet, daß die Sensoren (11 - 13) auf einer Trägerplatte (10) zusammen mit einer Auswerteschaltung (14) angeordnet sind.

9. Sensoreinrichtung nach Anspruch 8, dadurch gekennzeichnet, daß die Trägerplatte (10) als Si-Träger ausgebildet ist, wobei die Sensoren (11 - 13) und die Auswerteschaltung (14) eine durch einen Batch-Prozeß gebildete Struktur aufweisen.

10. Sensoreinrichtung nach einem der vorhergehenden Ansprüche, gekennzeichnet durch die Kombination mit einer Kolben-Zylinder-Einheit, wobei der Permanentmagnet (16) an oder in einem Kolben der Kolben-Zylinder-Einheit und die Sensoren (11 - 13) an oder in der Zylinderwandung angeordnet sind.

## Claims

1. Position sensor device with an element which has a permanent magnet (16) and is movable in a longitudinal direction, and with one or more magnetic-field-sensitive sensors (11, 12) fixed on the path of movement (15), characterized in that two first sensors (11, 12) are provided, responding to the field component at right-angles to the direction of movement of the permanent magnet (16) and arranged consecutively in this direction of movement, between which is located a third sensor (13) responding to the field component parallel to the direction of movement of the permanent magnet (16), wherein the response signals of the two first sensors (11, 12) form a measuring window to mask out stray signals of the third sensor (13) occurring besides the main signal, and the three sensors (11-13) are arranged consecutively in the direction of movement.

2. Sensor device according to claim 1, characterized in that the permanent magnet (16) is axially magnetized in the direction of movement.

3. Sensor device according to claim 1 or 2, characterized in that the two first sensors (11, 12) are Hall sensors.

4. Sensor device according to claim 3, characterized in that the Hall sensors (11, 12) are designed as uniaxial, bistable Hall sensors.

5. Sensor device according to claim 3 or 4, characterized in that electronic means (18) of creating the measuring window are provided which, when the two Hall sensors (11, 12) are in different switching states, generate a signal (U18) defining the measuring window.

6. Sensor device according to any of the preceding claims, characterized in that the third sensor (13) is in the form of a magneto-resistive sensor.

7. Sensor device according to any of the preceding claims, characterized in that the sensors (11 - 13) are arranged adjacent to one another as flat chips in a single plane.

8. Sensor device according to claim 7, characterized in that the sensors (11 - 13) are arranged on a mounting plate (10) together with an evaluation circuit (14).

9. Sensor device according to claim 8, characterized in that the mounting plate (10) is in the form of a Si support, wherein the sensors (11 - 13) and the evaluation circuit (14) have a structure formed through a batch process.

10. Sensor device according to any of the preceding claims, characterized by combination with a piston-cylinder unit, wherein the permanent magnet (16) is located on or in a piston of the piston-cylinder unit, and the sensors (11 - 13) are on or in the cylinder wall.

## Revendications

1. Dispositif à capteurs de position comportant un élément déplaçable dans une direction longitudinale et comportant un aimant permanent (16), ainsi qu'au moins un capteur (11, 12) réagissant au champ magnétique, disposé stationnaire sur la trajectoire (15), caractérisé en ce que sont prévus deux premiers capteurs (11, 12) réagissant à la composante de champ perpendiculaire à la direction de déplacement de l'aimant permanent (16) et disposés l'un derrière l'autre dans cette direction de déplacement, capteurs entre lesquels est disposé un troisième capteur (13) réagissant à la composante de champ parallèle à la direction de déplacement de l'aimant permanent (16), les signaux de réponse des deux premiers capteurs (11, 12) formant une fenêtre de mesure pour supprimer des signaux secondaires du troisième capteur (13), apparaissant en plus du signal principal et les trois capteurs (11 à 13) étant disposés l'un derrière l'autre dans la direction de déplacement.

2. Dispositif à capteurs selon la revendication 1, caractérisé en ce que l'aimant permanent (16) est magnétisé axialement dans la direction de déplacement.

3. Dispositif à capteurs selon la revendication 1 ou 2, caractérisé en ce que les deux premiers capteurs (11, 12) sont des capteurs de Hall.

4. Dispositif à capteurs selon la revendication 3, caractérisé en ce que les capteurs de Hall (11, 12) sont réalisés sous la forme de capteurs de Hall bistables à un axe.

5. Dispositif à capteurs selon la revendication 3 ou 4, caractérisé en ce que sont prévus des moyens électroniques (18) pour la formation de la fenêtre de mesure, qui produisent un signal (U18) définissant la fenêtre de mesure en cas d'inégalité de l'état de commutation des deux capteurs de Hall (11, 12).

6. Dispositif à capteurs selon l'une des revendications précédentes, caractérisé en ce que le troisième capteur (13) est réalisé sous la forme d'un capteur magnétorésistif.

7. Dispositif à capteurs selon l'une des revendications précédentes, caractérisé en ce que les capteurs (11 à 13) sont des plaquettes plates juxtaposées dans un plan.

8. Dispositif à capteurs selon la revendication 7, caractérisé en ce que les capteurs (11 à 13) sont disposés sur une plaque de support (10) avec un circuit de traitement (14).

9. Dispositif à capteurs selon la revendication 8, caractérisé en ce que la plaque de support (10) est réalisée sous la forme d'un support en silicium, les capteurs (11 à 13) et le circuit de traitement (14) présentant une structure formée par un procédé Batch (fabrication collective).

10. Dispositif à capteurs selon l'une des revendications précédentes, caractérisé par sa combinaison avec un ensemble à cylindre et piston, l'aimant permanent (16) étant disposé sur ou dans un piston de l'ensemble à cylindre et piston et les capteurs (11 à 13) étant prévus sur ou dans la paroi du cylindre.
